Europäisches Patentamt

European Patent Office

Office européen des brevets

(19)

(11) Veröffentlichungsnummer: **0 027 629**
**B1**

(12) **EUROPÄISCHE PATENTSCHRIFT**

(45) Veröffentlichungstag der Patentschrift:
**12.10.83**

(21) Anmeldenummer: **80106237.3**

(22) Anmeldetag: **14.10.80**

(51) Int. Cl.³: **H 01 L 23/32,** H 01 L 25/08 //
**H01L21/60**

(54) **Halbleiterbauelement mit wenigstens einem oder mehreren Halbleiterkörpern.**

(30) Priorität: **19.10.79 DE 2942401**

(43) Veröffentlichungstag der Anmeldung:
**29.04.81 Patentblatt 81/17**

(45) Bekanntmachung des Hinweises auf die Patenterteilung:
**12.10.83 Patentblatt 83/41**

(84) Benannte Vertragsstaaten:
**FR GB SE**

(56) Entgegenhaltungen:

**DE-A-2 224 040**
**DE-A-2 351 637**
**FR-A-2 395 603**
**US-A-3 651 383**
**US-A-3 972 063**
**US-A-3 982 308**

(73) Patentinhaber: **SIEMENS AKTIENGESELLSCHAFT,**
**Berlin und München Wittelsbacherplatz 2,**
**D-8000 München 2 (DE)**

(72) Erfinder: **Bahlinger, Walter, Eduard-Schenkstrasse 68,**
**D-8000 München 40 (DE)**

## Halbleiterbauelement mit wenigstens einem oder mehreren Halbleiterkörpern

Die Erfindung bezieht sich auf ein Halbleiterbauelement mit wenigstens einem oder mehreren Halbleiterkörpern, die in einem einen metallenen Boden aufweisenden Gehäuse angeordnet sind und durch je eine blattförmige Feder über Zuleitungen elektrisch druckkontaktiert sind und mittels der Anpresskraft der Feder auch in wärmeleitendem Kontakt mit dem Boden stehen.

Solche Halbleiterbauelemente sind bereits bekannt (DE-A-2 224 040 und US-A-3 972 063), wobei die Blattfeder mittels Schraubenbolzen, die durch Öffnungen in den Enden der Blattfeder gehen, gespannt wird. Zur Vermeidung von auf die Schraubenbolzen wirkenden Scherkräften, die von der Auslenkung der Blattfeder herrühren, ist gemäss der DE-A-2 224 040 jeder Schraubenbolzen in eine Hülse gesteckt, über die ein zusätzliches Ausgleichsstück geschoben wird. Diese Ausgleichsstücke dienen zur Übertragung der Spannkräfte von der Spannfeder auf die Spannmuttern und Spannschrauben und besitzen einen dreieckförmigen Querschnitt wobei die Spitze dieses Dreiecks auf der Oberfläche der blattförmigen Spannfeder aufliegt, um eine Verkantung dieser Oberfläche zu vermeiden und die unter einem Winkel angreifende Spannkraft der Blattfeder in die Auswirkung der Spannschrauben umzulenken.

Diese bekannten Spannvorrichtungen erzwingen Federn, deren Länge im Verhältnis zur Breite gross ist. Der Hebelarm wird damit ebenfalls gross. Hinzu kommt, dass die beiden Schrauben je die Hälfte des Kontaktdruckes aufnehmen müssen. Das bedingt einen grossen Schraubendurchmesser, so dass die Schraubenmittellinie relativ weit vom Scheibenmittelpunkt entfernt zu liegen kommt. Das ergibt zusammen ein relativ hohes, auf den Boden des Halbleiterbauelementes einwirkendes Biegemoment, das den Boden verformt und die Wärmeabfuhr durch den Boden zu einem Kühlkörper verschlechtert.

Da bei einem solchen Halbleiterbauelement die Wärme fast ausschliesslich durch den Boden abgeführt wird, muss dieser möglichst dünn sein. Das Biegewiderstandsmoment des Bodens wird damit relativ gering, so dass es bei den hohen Kontaktdrucken zu kräftigen Verformungen des Bodens kommt. Der Federdruck ist ausserdem nicht genau einstellbar, da dieser nur über das Anzugsmoment der Schrauben bestimmt werden kann und somit vom Reibbeiwert der Teile Feder, Schrauben, Boden abhängt.

Der Erfindung liegt die Aufgabe zugrunde, ein Halbleiterbauelement der bekannten Art so weiterzubilden, dass der Boden bei gleicher Federkraft geringer verformt wird. Ausserdem soll diese Federkraft exakt einstellbar sein.

Die Erfindung ist dadurch gekennzeichnet, dass beide Enden der blattförmigen Feder mit einem Joch gehalten sind, das über mindestens zwei Schrauben im Gehäuseboden verankert ist.

Weiterbildungen der Erfindung sind Gegenstand der Unteransprüche.

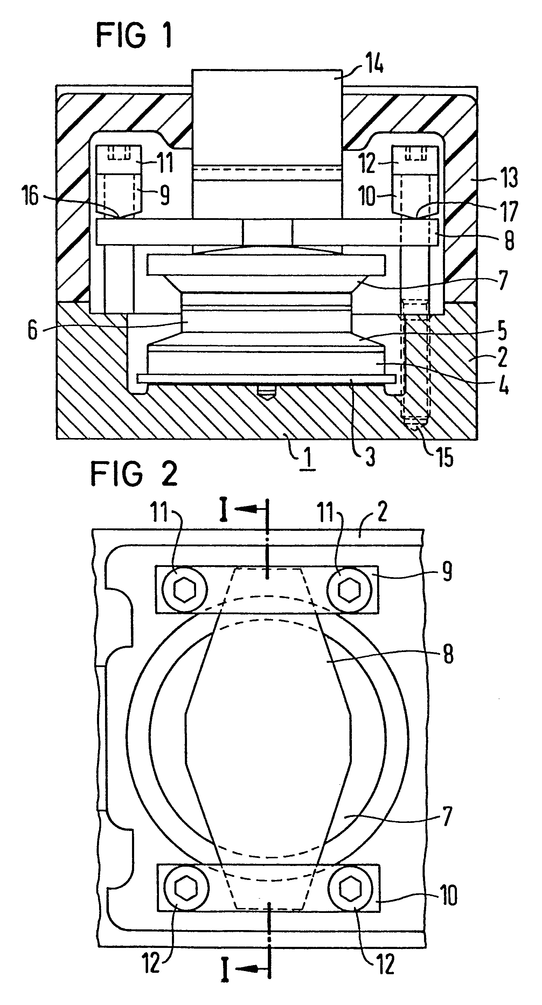

Die Erfindung wird anhand eines Ausführungsbeispiels in Verbindung mit den Fig. 1 und 2 näher erläutert.

Es zeigen:

Fig. 1 den Schnitt durch das Halbleiterbauelement und

Fig. 2 die Aufsicht auf das Innere eines Ausschnittes des gleichen Halbleiterbauelementes.

Das Halbleiterbauelement weist einen metallenen Boden 1 auf, der zum Beispiel aus Aluminium oder auch aus Kupfer besteht. Der Boden 1 kann wannenförmig ausgebildet sein und ist dann mit einer Wand 2 versehen. Auf dem Boden 1 liegt eine Scheibe 3, die aus elektrisch isolierendem, jedoch thermisch sehr gut leitendem Material wie Aluminiumoxid oder Berylliumoxid besteht. Auf dieser Scheibe liegen der Reihe nach folgende Teile: eine erste Zuleitung 4, ein Halbleiterkörper 5, eine zweite Zuleitung 6 und ein Druckstück 7. Auf dem Druckstück 7 liegt eine Blattfeder 8 auf. Auf den Enden der Blattfeder 8 liegen Joche 9, 10, die durch Schrauben 11, 12 mit dem Boden 1 des Halbleiterbauelementes verankert sind. Diese Joche sind länger als die Blattfedern an ihren Enden breit sind. Dadurch ist es möglich, die Federn ohne die für die Schrauben benötigten Löcher zu haltern. Die Schrauben können damit näher an der Mitte der Halbleiterkörper angeordnet werden. Jede der Schrauben muss ausserdem nur noch ein Viertel des Kontaktdruckes aufnehmen, so dass der Schraubendurchmesser kleiner als bei Verwendung nur zweier Schrauben gemacht werden kann und die Schraubenmittellinie entsprechend noch dichter an den Halbleiterkörper heranrücken kann. Damit ergibt sich insgesamt eine erhebliche Verringerung des Hebelarms und dadurch ein geringeres auf den Boden ausgeübtes Biegemoment. Die Verformungen des Bodens werden daher bei gleicher Dimensionierung geringer sein. Ausserdem ist die Anordnung besonders platzsparend.

Der Kontaktdruck wird zunächst mittels einer auf die Joche 9, 10 aufgesetzten Druckvorrichtung eingestellt. Dann werden die Schrauben bis zum Anschlag auf dem Joch festgezogen und die Druckvorrichtung entfernt. Der notwendige Kontaktdruck ist damit genau fixiert. Vorteilhafterweise sind die Joche 9, 10 mit je einer Schneide 16, 17 versehen, wodurch die Schrägstellung der gespannten Blattfeder nicht auf die Schrauben übertragen wird. Damit ist eine weitere Erleichterung der Einstellung des präzisen Kontaktdruckes gegeben. Es empfiehlt sich, die Blattfedern an ihren Enden trapezförmig auszubilden. Damit können die Joche kurz gehalten werden, so dass ihre Verformung praktisch unberücksichtigt bleiben kann. Die trapezförmige Blattfeder hat ausserdem den Vorzug, dass sie eine flachere Kennlinie als eine rechteckige Blattfeder hat. Der auf diese Weise zur Verfügung stehende grössere Federweg reduziert das Absinken der Anpresskraft, das sich im Lauf der Zeit bei den unvermeidlichen plastischen Verformungen der zu verspannenden Teile einstellt.

Die wannenförmige Ausbildung des Gehäusebodens 1 erhöht das Widerstandsmoment des Bodens und ermöglicht das Verankern der Schrauben durch in der Wand 2 vorgesehene Gewindesacklöcher 15.

Das Halbleiterbauelement wird durch einen zum Beispiel aus Kunststoff bestehenden Deckel 13 abgedichtet, durch den eine Zuführungselektrode 14 hindurchgeht. Die in Fig. 1 sichtbare Zuführungselektrode 14 kann entweder mit der ersten Zuleitung 4 oder mit der zweiten Zuleitung 6 elektrisch verbunden sein.

**Patentansprüche**

1. Halbleiterbauelement mit wenigstens einem oder mehreren Halbleiterkörpern (5), die in einem einen metallenen Boden (1) aufweisenden Gehäuse angeordnet sind und durch je eine blattförmige Feder (8) über Zuleitungen (4, 6) elektrisch druckkontaktiert sind und mittels der Anpresskraft der Feder (8) auch in wärmeleitendem Kontakt mit dem Gehäuseboden (1) stehen, dadurch gekennzeichnet, dass beide Enden der blattförmigen Feder (8) mit einem Joch (9, 10) gehalten sind, das über mindestens zwei Schrauben (11, 12) im Gehäuseboden (1) verankert ist.

2. Halbleiterbauelement nach Anspruch 1, dadurch gekennzeichnet, dass die Joche (9, 10) mit einer auf den Enden der blattförmigen Feder (8) aufliegenden Schneide (16, 17) versehen sind.

3. Halbleiterbauelement nach Anspruch 1 oder 2, dadurch gekennzeichnet, dass die Joche (9, 10) an jedem ihrer Enden mit einer Schraube (11, 12) im Boden (1) verankert sind.

4. Halbleiterbauelement nach einem der Ansprüche 1 bis 3, dadurch gekennzeichnet, dass die blattförmige Feder (8) an beiden Enden trapezförmig ausgebildet ist, wobei die kürzeren Seiten der parallelen Trapezseiten die blattförmige Feder (8) beidseitig begrenzen.

5. Halbleiterbauelement nach einem der Ansprüche 1 bis 4, dadurch gekennzeichnet, dass der Boden (1) wannenförmig ausgebildet und mit Wänden (2) versehen ist und dass die Schrauben (11, 12) in in den Wänden (2) vorgesehenen Gewindesacklöchern (15) sitzen.

**Claims**

1. A semiconductor component having one or more semiconductor bodies (5) which are arranged in a housing having a metallic base (1) and which are in each case electrically pressure-contacted by a leaf spring (8) by way of supply leads (4, 6) and are also in thermally-conducting contact with the base (1) of the housing by the pressing force of the spring (8), characterised in that each end of the leaf spring (8) is held by means of a respective yoke (9, 10) which is fixed to the base (1) of the housing by means of at least two screws (11, 12).

2. A semiconductor component as claimed in claim 1, characterised in that the yokes (9, 10) are each provided with a knife edge (16, 17) resting on a respective end of the leaf spring (8).

3. A semiconductor component as claimed in claim 1 or claim 2, characterised in that, at each of their ends, the yokes (9, 10) are secured to the base (1) by means of a screw (11, 12).

4. A semiconductor component as claimed in one of claims 1 to 3, characterised in that the leaf spring (8) is trapezium shaped at its ends, the shorter of the parallel sides of the trapezium bounding the leaf spring (8) at both ends.

5. A semiconductor component as claimed in one of claims 1 to 4, characterised in that the base (1) is trough-shaped and is provided with walls (2), and that the screws (11, 12) are positioned in threaded blind holes (15) which are arranged in the walls (2).

**Revendications**

1. Composant à semiconducteurs comportant au moins un ou plusieurs corps semiconducteurs (5) qui sont disposés dans un boîtier présentant un fond métallique (1) et qui sont contactés par respectivement un ressort en forme de lame (8) par l'intermédiaire de lignes d'amenée électriques (4, 6) et qui sont à l'aide de la force d'application des ressorts (8), également en contact thermique avec le fond (1) du boîtier, caractérisé par le fait que les deux extrémités du ressort à lame (8) sont maintenues par un étrier (9, 10) qui est ancré dans le fond (1) du boîtier, par l'intermédiaire d'au moins deux vis (11, 12).

2. Composant à semiconducteurs selon la revendication 1, caractérisé par le fait que les étriers (9, 10) sont pourvus d'un tranchant (16, 17) qui porte contre l'extrémité du ressort (8) en forme de lame.

3. Composant à semiconducteurs selon la revendication 1 ou 2, caractérisé par le fait que les étriers (9, 10) sont ancrés à chacune de leurs extrémités avec une vis (11, 12) dans le fond (1).

4. Composant à semiconducteurs selon l'une des revendications 1 à 3, caractérisé par le fait que le ressort (8) en forme de lame est réalisé, aux deux extrémités, en forme de trapèze, les côtés les plus courts des côtés parallèles du trapèze limitant, sur les deux côtés, le ressort (8) en forme de lame.

5. Composant à semiconducteurs selon l'une des revendications 1 à 4, caractérisé par le fait que le fond (1) a la forme d'une cuvette et est pourvu de parois (2) et que les vis (11, 12) sont montées dans des taraudages borgnes (15) prévus dans les parois (2).

FIG 1

FIG 2